# EUROPEAN PATENT SPECIFICATION

(11) **EP 4 376 072 B1**
(45) Date of publication and mention of the grant of the patent: **30.07.2025**
(21) Application number: 23203555.0
(22) Date of filing: 13.10.2023
(51) Int. Cl.: H01L 23/495, H01L 23/31

(54) **METHOD OF MANUFACTURING SEMICONDUCTOR DEVICES, CORRESPONDING SEMICONDUCTOR DEVICE, ASSEMBLY AND SUPPORT SUBSTRATE**
VERFAHREN ZUR HERSTELLUNG VON HALBLEITERBAUELEMENTEN, ZUGEHÖRIGES HALBLEITERBAUELEMENT, ANORDNUNG UND TRÄGERSUBSTRAT
PROCÉDÉ DE FABRICATION DE DISPOSITIFS SEMI-CONDUCTEURS, DISPOSITIF SEMI-CONDUCTEUR CORRESPONDANT, ENSEMBLE ET SUBSTRAT DE SUPPORT

(30) Priority: 02.11.2022 IT 202200022422
(43) Date of publication of application: 29.05.2024
(73) Proprietor: STMicroelectronics S.r.l., 20864 Agrate Brianza (MB) (IT)
(72) Inventor: DE SANTA, Matteo, 20883 Mezzago (Monza Brianza) (IT); MAZZOLA, Mauro, 24040 Calvenzano (Bergamo) (IT)
(74) Representative: Buzzi, Notaro & Antonielli d'Oulx S.p.A.

(56) References cited:
- JP-A- 2010 050 491
- JP-A- H11 145 369
- US-A1- 2016 254 214

## Description

### Technical field

The description relates to manufacturing semiconductor devices.

Solutions as described herein can increase the reliability of Quad-Flat No-Leads, QFN packages, such as, for instance power QFN packages, for automotive products.

### Background

So-called wettable flanks in semiconductor device packages are desirable for facilitating automatic optical inspection of solder joints after assembly on a mounting surface (a printed circuit board, PCB, for instance) .

Wettable flanks of increased height are particularly desirable; however, wettable flank height may be limited to half the leadframe thickness if half-etched tie bars are provided during packaging to keep leads in place.

Also, defects in wedge contact between wire/ribbon and a corresponding lead may result in a failure of the whole unit, e.g., due to issues related to wire bonding, notably weld off/weld lift.

Document JP H11 145 369 A discloses a lead frame comprising a tab whereon a semiconductor chip is mounted, an inner lead which is provided with a wire connection made lower than the tip and is electrically connected with the pad of the above semiconductor chip, at the wire connection through a bonding wire, a sealing body which is made by sealing the above semiconductor chip and the bonding wire with resin, and an outer lead which is projected outward from this sealing body. A wire connection which is a circular recess formed lower than the tip is made in the vicinity of the tip of the inner lead.

Document JP 2010 050491 A discloses a semiconductor device including: a semiconductor chip having a plurality of pads; a plurality of leads each having a mounting surface and a wire connection surface, each including a thick part and a thin part having a thickness smaller than that of the thick part, and each formed so that the length of the wire connection surface is smaller than that of the mounting surface; a plurality of wires for connecting the semiconductor chip to the leads; and a sealing body formed of a resin. The thin part of each lead is arranged by crawling into the lower part of the semiconductor chip and the leads 1a and the semiconductor chip are connected to each other through the wires by reverse bonding, whereby the package size is brought close to the chip size by reducing the distance from a side face of the semiconductor chip to a side face of the sealing body as much as possible while securing the length of the mounting surface of each lead and a QFN is downsized.

Document US 2016/254214 A1 discloses a method of manufacturing a semiconductor device wherein a lead frame is provided having a trench part formed thereon so as to communicate bottom surfaces of a first lead and a second lead, which are coupled to each other between device regions adjacent to each other. After a part of a coupling part between the first and second leads is cut by using a first blade, metal wastes formed inside the trench part are removed. After the metal wastes are removed, a metal film is formed on exposed surfaces of the first and second leads by a plating method, and then, a remaining part of the coupling part between the first and second leads is cut by using a second blade. At this time, the cutting is performed so that the second blade does not contact the trench part.

### Object and summary

Solutions as described herein aim at addressing the issues discussed in the foregoing.

Such an object can be achieved via a method having the features set forth in the claims that follow.

One or more embodiments relate to a corresponding semiconductor device.

One or more embodiments relate to a corresponding assembly (a semiconductor device plus a mounting member therefor, e.g., a printed circuit board, PCB).

One or more embodiments relate to a support substrate (e.g., a leadframe for use in manufacturing semiconductor devices).

The claims are an integral part of the technical teaching provided in respect of the embodiments.

Solutions as described herein provide a leadframe design and wire bonding scheme for wettable flanks (e.g. for QFN packages) that increases the total height of the wettable flanks while also providing an additional and direct electrical path between wire/ribbon and solder joint in case of weld failure.

Solutions as described herein may include leads comprising half-etched, outwards extending recessed portion.

Solutions as described herein contemplate providing a leadframe, mounting a die thereon, forming electrical connections between the die and leads in the leadframe through wire/ribbon bonding.

In solutions as described herein a second bond is formed in the recessed portion of the lead and a wire/ribbon tail extends outwardly of the recessed portion.

In solutions as described herein an encapsulation is molded and partial sawing of leads facilitates forming wettable flanks.

In solutions as described herein, partial sawing extends into the wire/ribbon tail and exposes a flank portion thereof.

In solutions as described herein tin plating of the partially cut leads and exposed portion of wire/ribbon follows.

Solutions as described herein facilitate wettable flanks/solder join inspection, e.g., package flank optical inspection (a wire/ribbon section is visible on package sides) and/or package X-ray inspection (where recessed lead portions are visible).

### Brief description of the several views of the drawings

One or more embodiments will now be described, by way of example only, with reference to the annexed figures, wherein:
Figure 1 is a partial cross-sectional view through a semiconductor device,
Figure 2 is a partial perspective view showing certain possible details of the semiconductor device of Figure 1,
Figure 3 is a plan view of a power semiconductor device to which embodiments of the present description may apply,
Figure 4 is a view of the portion of Figure 3 indicated by the arrow IV, reproduced on an enlarged scale,
Figure 5 is a view of the portion of Figure 3 indicated by the arrow V, reproduced on an enlarged scale,
Figures 6 to 12 (wherein Figure 7 is a cross-sectional view along line VII-VII of Figure 6) are illustrative of a possible sequence of steps in manufacturing a semiconductor device,
Figures 13 to 19 (wherein Figure 14 is a cross-sectional view along line XIV-XIV of Figure 13) are illustrative of a possible sequence of steps in manufacturing a semiconductor device according to embodiments of the present description,
Figure 20 is a view of the portion of Figure 19 indicated by the arrow XX, reproduced on an enlarged scale,
Figures 21A and 21B are perspective views illustrative of the possible result of the sequence of steps of Figures 13 a 19, and
Figure 22 is illustrative of a possible variant of embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

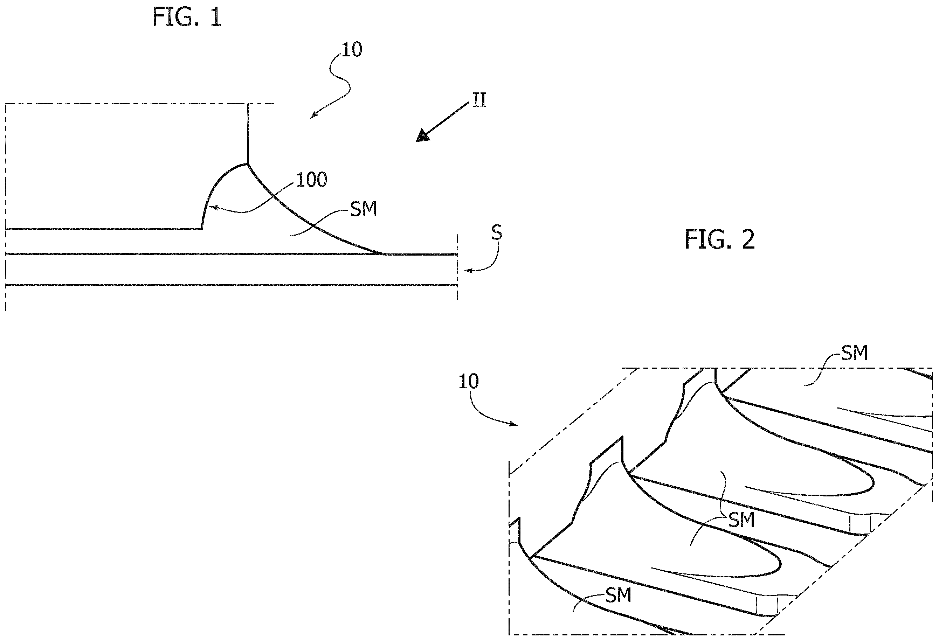

Figure 1 is a partial cross-sectional view through a semiconductor device 10 mounted (attached) on a support member S such as a printed circuit broad, PCB.

As illustrated in Figure 1, attachment is via solder material SM and various device packages (e.g., for the automotive market) have a geometry feature 100 on the lead sides, called wettable flanks.

This feature facilitates formation of a meniscus in the solder material SM when soldering the device 10 on a support member, e.g., PCB.

Wettable flanks facilitate automatic optical inspection insofar as the solder meniscus is visible.

As illustrated herein by way of example, a semiconductor device such as the device 10 comprises:
a substrate (leadframe) 12 having one or more (integrated circuit) semiconductor chips or dice 14 arranged thereon,
electrically conductive formations (wires, ribbons, clips) 16 coupling the semiconductor chip(s) 14 to leads (outer pads) in the substrate, and
an insulating encapsulation (e.g., a resin) 18 molded on the assembly thus formed to complete the plastic body of the device 10.

As used herein, the terms chip/s and die/dice are regarded as synonymous

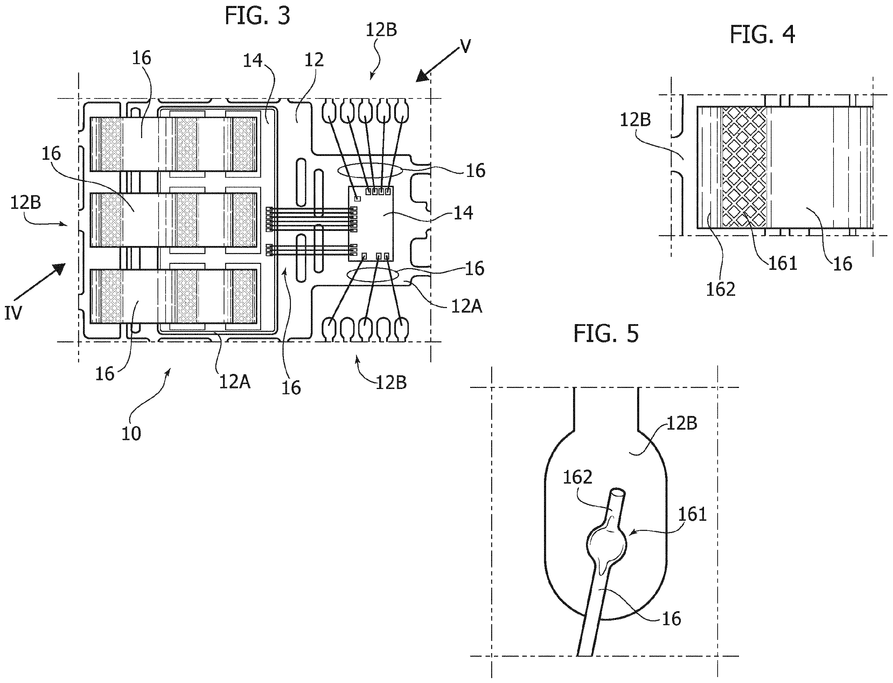

Figures 3 to 5 illustrate a power semiconductor device 10 comprising a low-power section (e.g., a controller die, illustrated on the right-hand side of Figure 3) attached on a first die pad in the leadframe 12 and a high-power section (e.g., one or more power dice illustrated on the left-hand side Figure 3) attached on one or more die pads in the lead frame 12, with an array of leads around the die pads having the low-power and the high-power dice mounted thereon.

The current transferred from the high-power section to the output pads of the device can be significant. As shown on the left-hand side of Figure 3, ribbons or clips 16 are thus used for that purpose in the place of wires. Wires, likewise indicated as 16 can still be used as shown on the right-hand side of Figure 3 to provide electrical coupling to a low-power section (e.g., a controller) in the device.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Essentially, a leadframe comprises an array of electrically-conductive formations (or leads, e.g., 12B) that from an outline location extend inwardly in the direction of a semiconductor chip or die (e.g., 14) thus forming an array of electrically-conductive formations from a die pad (e.g., 12A) configured to have at least one semiconductor chip or die attached thereon. This may be via conventional means such as a die attach adhesive (a die attach film or DAF, for instance).

Again, as illustrated in Figures 3 to 5, electrically conductive formations are provided comprising wire bonding patterns 16 coupling the low-power section (right-hand side of Figure 3) to selected ones of the leads 12B and to the high-power section (left-hand side of Figure 3) . These wire bonding patterns are coupled to die pads provided at the front or top surfaces of the chips.

Conversely, so-called ribbons are used to couple the high-power section (left-hand side of Figure 3) to selected ones of the leads 12B acting as (power) output pads of the device 10. Using ribbons in the place of wires accounts for the fact that the current transferred from the high-power section to the output pads in a power semiconductor device may be significant.

A device structure as discussed so far is conventional in the art, which makes it unnecessary to provide a more detailed description herein.

A single (integrated circuit) chip or die 14 mounted on a single die pad 12A will be considered throughout the rest of this description for simplicity.

The leadframe 12 is the base material support for the device 10. It is made of, e.g., copper, and shaped to accommodate semiconductor dice and generate pad connections.

Photo-etching can be advantageously used for leadframe manufacturing: a sheet or strip of copper material is etched on top and bottom side to create die pads and leads.

Pads/leads are connected together by sacrificial connecting bars. Wedge-wedge bonding could be used to bond wires. Plating treatments are also applied as desired.

Wedge(-wedge) bonding is a current designation for wire/ribbon bonding technology that use force and ultrasonic power in order to create an interconnection between a surface (e.g., a leadframe 12/a die 14) and a wire/ribbon as designated by 16 in figures: in fact, Wedge bonding technology can be applied to both wires and ribbons.

As illustrated, e.g., in Figures 4 and 5, the (welded) connection of a wire and/or ribbon 16 to a die/leadframe surface includes two sections:
a proximal section (wedge section proper) 161, and
a distal section (tail formation) 162.

The proximal wedge section 161 carries the current/signal, while distal tail 162 does not contribute appreciably to signal transport, because that section is not welded to the die/leadframe surface.

After molding of the encapsulation 18, the device package is sealed. Dice 14 and wires/ribbons 16 are no longer accessible from the outside.

Any detachment between a wire/ribbon 16 and a corresponding lead 12B, for instance, will result in a failure of the whole device 10. Wire bonding related issues may represent a major source of device failure.

A method to provide wettable flanks on a device package is by sawing.

This approach relies on the fact that, in current manufacturing processes of semiconductor devices, plural devices are manufactured together and separated into single individual device in a final singulation (sawing) step.

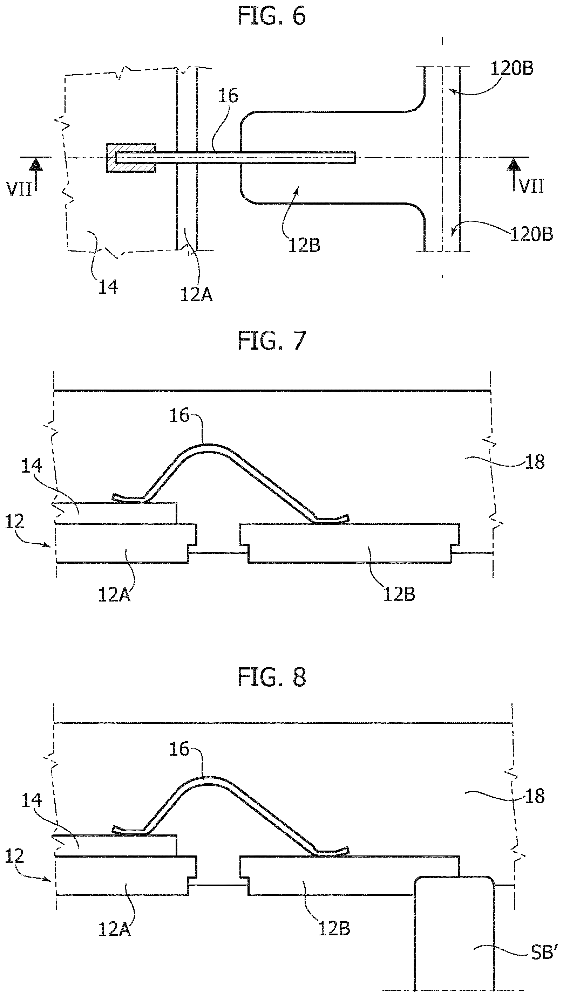

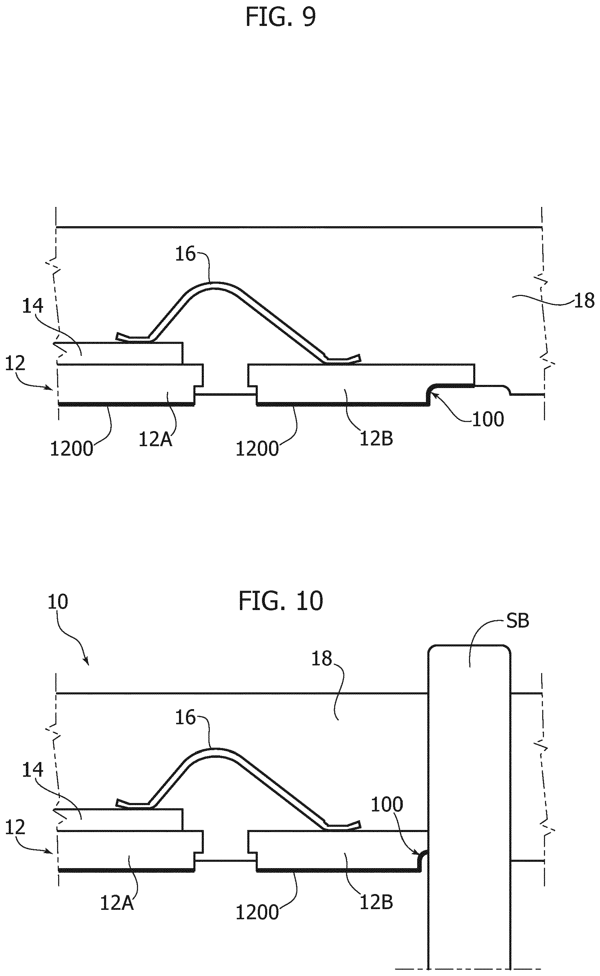

That is, after a chain of devices 10 formed on a common leadframe strip is assembled (dice, wires and molding: see Figures 6 and 7), individual devices 10 are separated via singulation as represented in Figure 10 using a sawing blade SB.

As illustrated in Figures 8 and 9, prior to the final singulation, the leadframe 12 is partially sawn (engraved) using a circular saw SB' (this may be the same singulation blade SB or a different blade) that partially cuts the common leadframe strip material at pad (lead) level between adjacent devices, that is, at the device flanks. Pads (leads) remain connected together via connecting bars provide to facilitate electrical connection for plating.

Plating as indicated by 1200 is applied to the whole leadframe 12 so that all exposed pad areas (die pads 12A and leads 12B) will be plated.

Final singulation as illustrated in Figure 10 is then applied, cutting (e.g., via a saw SB) all the materials starting from the bottom or back surface of the leadframe 12 till the top of the package. As a result, each packaged device 10 is separated from manufacturing chain.

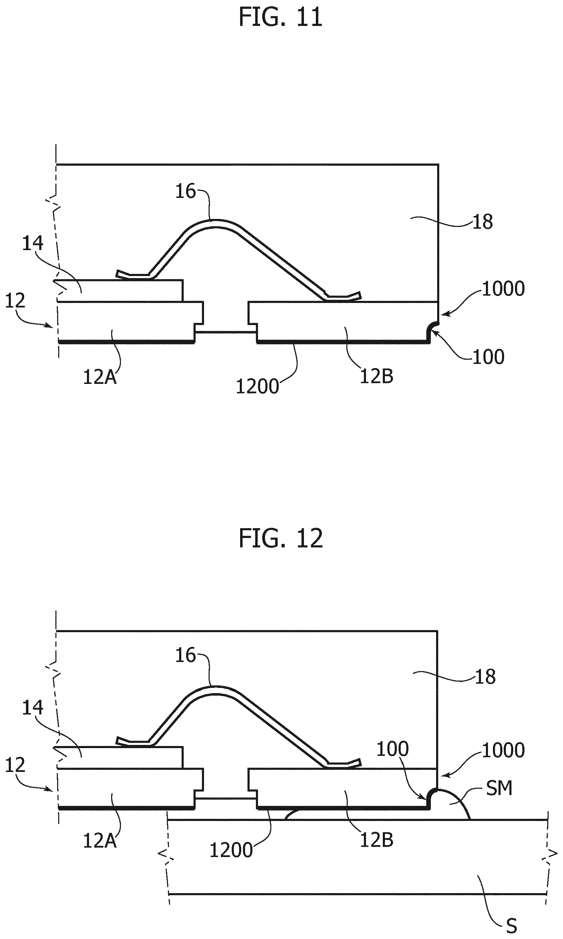

As illustrated in Figures 11 and 12, a device 10 thus produced will have an external flank surface plated area extending only on that part of the lead shape that does not derive from cutting during singulation: that portion of the wettable flanks produced from cutting (that is, that portion exposed as result of cutting during singulation, as indicated by 1000 in Figures 11 and 12) will have exposed - and unplated - leadframe material (copper) on the external package side.

As noted, solder SM is applied in order to connect the device package to a board S. Meniscus will appear after soldering.

Electrical connection between the solder SM (the board S) and wire/ribbon 16 takes place primarily through the metal (copper) lead 12B. In case of detachment between wire 16 and lead 12B, the device will likely fail with no possibility of recovery.

For simplicity a wire/lead is illustrated throughout Figures 6 to 22, but the same discussion also applies to a ribbon.

At least in principle, the risk of weld off/lift can be reduced keeping the assembly process as stable as possible, e.g., performing "in process control": input and output key parameters are checked according to a process control plan, and output parameters are monitored and checked (e.g., wire/ribbon pull and shear test). Electrical testing can also be envisaged.

In process control is performed with a specific sample size and frequency: 100% checks are hardly feasible. Visual inspection of the connection between a wire and a lead can be performed before molding step only. Electrical testing can evaluate the interconnection during the test phase only: possible evolution and consequent failure of the interconnection cannot be predicted.

Solutions as exemplified herein contemplate providing a recessed region 200 in the front or top surface of the leads 12B and forming the wedge bond to the wire/ribbon 16 in such dedicated recessed region of the lead.

Such a recessed area 200 can be provided, e.g., by chemical etching, coining, laser machining, or other conventional technologies known to those of skill in the art. For instance, such recessed areas or regions 200 can be formed at the leads 12B during leadframe manufacturing.

Such recessed areas or regions 200 can have different shapes.

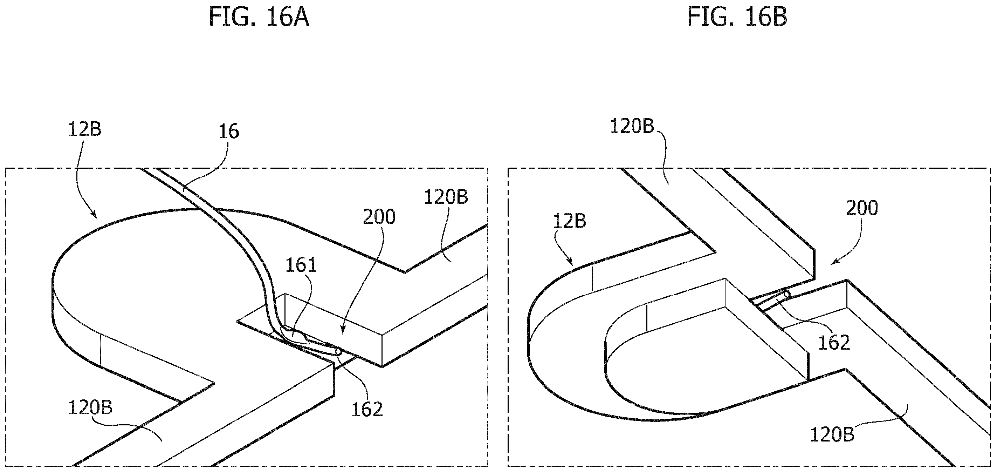

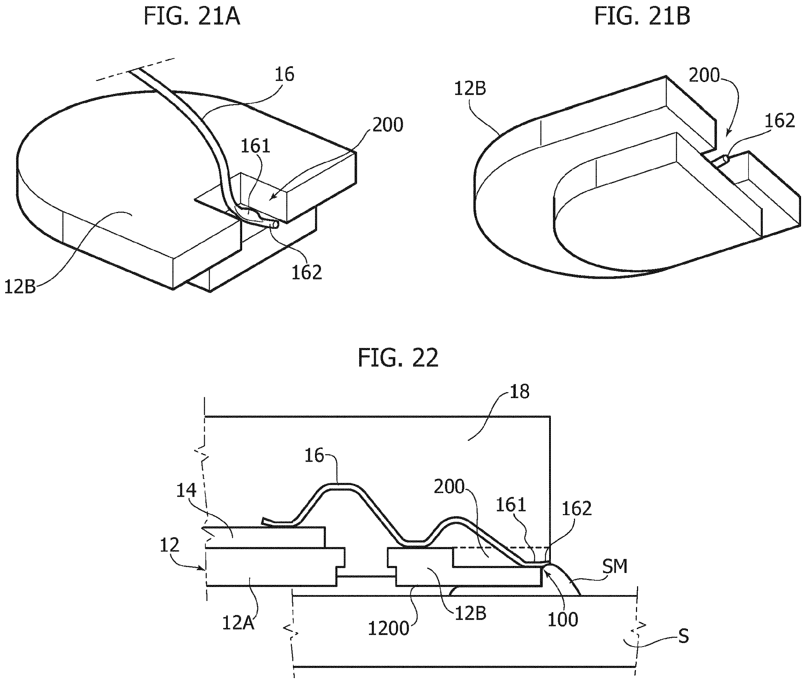

As visible in Figures 16A and 16B (and Figures 21A and 21B - that refer to a condition after removal of the sacrificial tie bars 120B) the recessed portions 200 can be provided in individual leads 12B as a (e.g., rectangular) recess etched (in a manner known per se) in the metal (e.g., copper) of the sculptured structure of the leadframe 12.

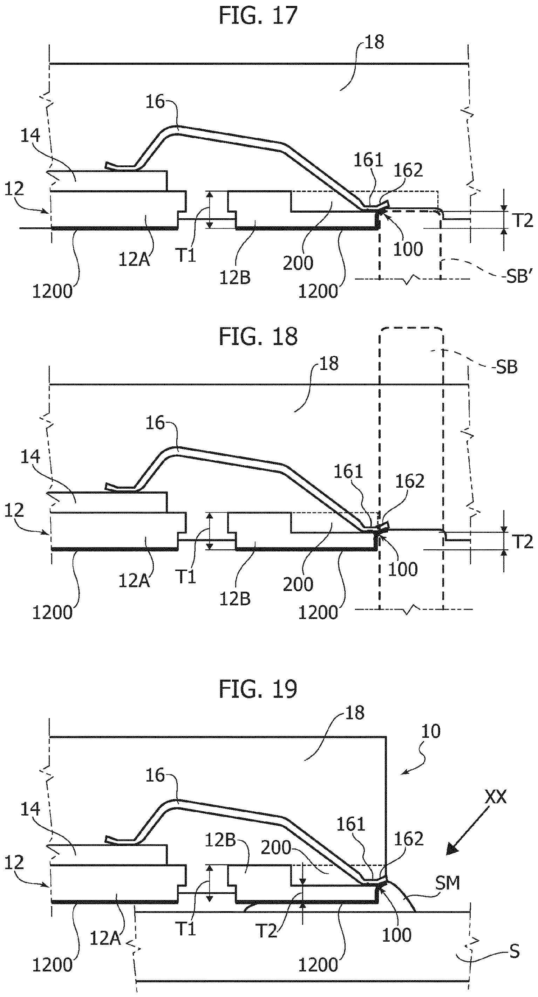

It is noted that Figures 16A and 16B (and Figures 21A and 21B as well) refer for clarity of representation:
to individual leads 12B illustrated in isolation from any other neighboring part (e.g., the encapsulation 18);
to leads 12B shown after a final singulation step (see Figure 18) that results in these etched recessed being cut about their half length, thus giving rise (in mutually facing leads 12B of adjacent devices 10 manufactured simultaneously and then singulated) to half-recesses in the form of notches cut in the flanks of these devices.

It is further noted that the leads 12B visible in the schematic representations of Figures 16A and 16B (and Figures 21A and 21B) have shapes that are different from the leads 12B of Figures 3 to 5 or Figures 6 and 13. This is intended to highlight the possibility for solutions as discussed herein to be applied to leads 12B having a wide variety of shapes.

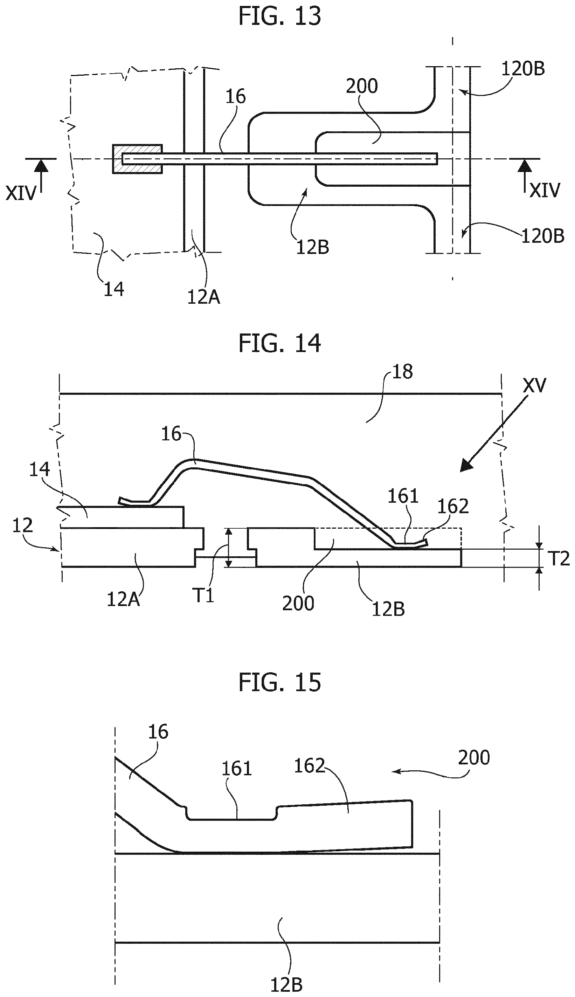

As noted, solutions as presented herein rely on the fact that in current manufacturing processes of semiconductor devices, plural devices 10 are manufactured concurrently to be separated into single individual device in a final singulation (sawing) step. That is, after a chain of devices 10 formed on a common leadframe strip is assembled (dice, wires and molding: see Figures 13 onwards), individual devices 10 are separated via singulation as represented in Figure 18 using a sawing blade SB.

Advantageously, the bond of the wire/ribbon 16 to the recessed portion 200 at the proximal section 161 (this may be formed, e.g., as a "second bond" in a wire bonding process where a "first bond" is formed at the chip or die 14: see, e.g., Figure 14) extends into a "long" distal, tail formation 162 long enough to cause the tail 162 to lie at (above) the wettable flank sawing area (see, e.g., Figures 15, 16A and 16B).

The first sawing step (see SB' in dashed lines in Figure 17) will cut through the (copper) lead 12B plus a portion of wire/ribbon thickness only, which is facilitated by a well-controlled sawing cut and relative wear of the blade SB').

Electrical connection between pads (leads) can still be maintained via a sacrificial connecting bar 120B that is still present.

Plating 1200 is again applied over the whole (back or bottom surface) of leadframe, with exposed pad/lead areas plated.

Final singulation (see the blade SB in Figure 19) will cut through the material thickness separating the individual devices 10, removing the connecting bars 120B as well.

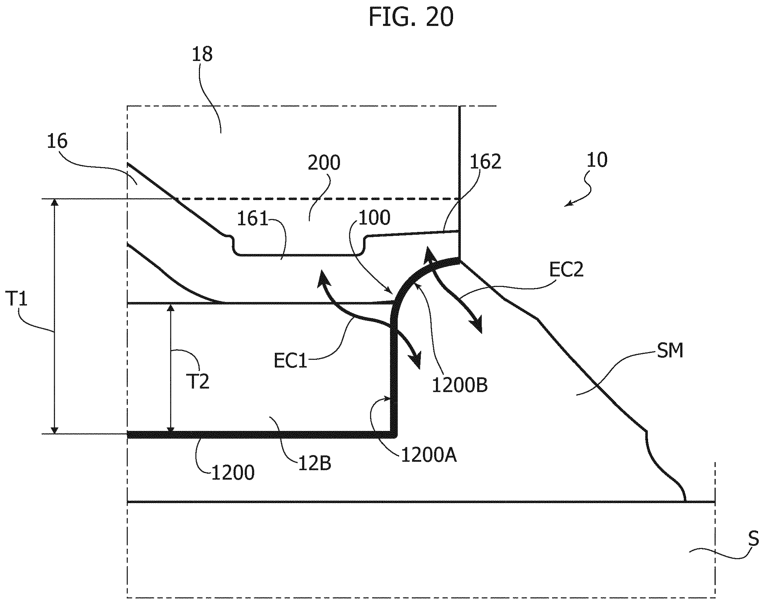

As visible in Figure 20, a device 10 thus produced will again have an external flank surface plated area extending on that part of the lead shape that does not derive from cutting during singulation.

That external flank surface will comprise:
a first (plated) portion 1200A resulting from the first (partial) cutting through the lead 12B;
a second (plated) portion 1200B resulting from the first (partial) cutting through (e.g., the tail 162 of) the wire/ribbon 16.

Only the end portion (e.g., the tail portion 162) of the wire/ribbon 16 exposed as result of cutting during singulation will have exposed - and unplated - leadframe material (copper) on the external package side.

As visible in Figures 21A and 21B (which represent the situation after removal of the sacrificial tie bars 120B) the recessed portions 200 can be provided in individual leads 12B as a (e.g., rectangular) recess etched (in a manner known per se) in the metal (e.g., copper) of the sculptured structure of the leadframe 12.

It is again noted that Figures 21A and 21B refer, for clarity of representation, to individual leads 12B illustrated in isolation from any other neighboring part (e.g., the encapsulation 18).

These leads 12B are shown after a final singulation step (see Figure 18) that results in these etched recessed being cut about their half length, thus giving rise (in mutually facing leads 12B of adjacent devices 10 manufactured simultaneously and then singulated) to half-recesses in the form of notches cut in the flanks of these devices.

The final device 10 will thus have a plated area shape for wettable flanks (except for a small portion of wire/ribbon) on the external package side.

Solder can thus be applied to connect the device 10 to the board S. Meniscus will be produced in the solder SM as a result of soldering.

As exemplified in Figure 20, electrical connection between the solder SM (the board S) and the wire/ribbon 16 will occur:
via the (copper) lead 12B as exemplified by EC1, and
via an additional connection path between the wire/ribbon 16 and the solder SM as exemplified by EC2.

In case of detachment between the wire/ribbon 16 and the lead 12B (connection EC1 fail), the device 10 can remain operable through the solder to wire/ribbon 16 connection (connection EC2).

To summarize, solutions as presented herein involve arranging at least one semiconductor die 14 on a die pad 12A at a first surface of a support substrate (leadframe) 12.

The support substrate 12 has a first thickness (indicated as T1 in the figures) between the first surface and a second surface opposite the first surface.

The support substrate (leadframe) 12 comprises an array of electrically conductive leads 12B around the die pad 12A.

Terminal recesses 200 (that is, recesses located at or in proximity of the distal end of the lead 12B concerned) are formed in (at least some of) the electrically conductive leads 12B in the array at the first surface of the leadframe 12 (that is, the surface onto which the die 14 is mounted).

At the terminal recesses 200, the leads 12B have a second thickness (indicated as T2 in the figures) that is less than the first thickness T1.

The electrically conductive, elongated formations such as the wires or ribbons 16 have coupling ends 161, 162 to the electrically conductive leads 12B arranged at the recesses 200.

Partially cutting (engraving) the leadframe 12 starting from the second surface as presented by reference SB' is carried out at the terminal recesses 200 with a cutting thickness Tx (depth) that lies between the first thickness T1 and the second thickness T2 (T1 > Tx > T2).

Partial cutting SB' thus produces exposed surfaces of the support substrate (see reference 1200A) and the coupling ends (see reference 1200B) of the wires or ribbons 16.

The insulating encapsulation 18 molded onto the semiconductor die 14 arranged on the die pad 12A at the first surface of the support substrate 12 leaves uncovered (as solder wettable flanks) the exposed surfaces of the support substrate 1200A and the coupling ends 1200B of the electrically conductive elongated formations 16 produced by partial cutting.

As illustrated, the coupling ends 161, 162 of the wires or ribbons 16 to respective leads 12B, comprise, arranged in the terminal recesses 200:
proximal portions 161 (e.g., wedge) bonded to selected ones of the electrically conductive leads 12B at the recesses 200, and
distal portions 162 projecting from the proximal portions 161 at the recesses 200.

As illustrated, the distal portions 162 are exempt from bonding to the leads 12B.

Advantageously, partial cutting SB' at the terminal recesses 200 with a cutting thickness between the first thickness (T1) and the second thickness (T2) takes place at the distal portions 162, thus producing exposed surfaces of the support substrate (leadframe, see reference 1200A) and of the distal portions 162 the coupling ends of the wires or ribbons 16.

As exemplified in Figures 19 and 20, the device 10 with the support substrate 12 having the semiconductor die or dice 14 arranged on the die pad 12A can be mounted onto a mounting member (such as a printed circuit board S) via solder material SM that wets and forms a solder meniscus at both exposed surfaces of the leadframe 12 (see reference 1200A) and of the coupling ends (see reference 1200B) of the wires or ribbons 16.

Embodiments as presented herein can be applied to any package that use a wire or ribbon welded through wedge-wedge bonding technology and take advantage from having a wettable flank.

Figure 22 is illustrative of a possible variant of embodiments of the present description where double or plural bonding is applied, e.g., to a wire 16.

It will be appreciated that the (first, partial) sawing line SB' can pass through proximal section 161 of the bond, thus also in the absence of a "long" distal, tail formation 162.

Wedge(-wedge) bonding as discussed herein can be performed using wires or ribbons made of aluminum, copper, gold or other materials suited to be bonded, e.g., with an ultrasonic process.

Solutions as discussed herein provide improved package reliability, e.g., as a result of solder meniscus SM directly connected to the wire/ribbon 16.

No additional process steps or costs are involved: solutions as discussed herein can be implemented using existing wire bonding machines.

Wire/ribbon tails can be made accessible from the outside of the device package. Wettable flanks may have a direct connection between wire and solder, when mounted on board.

Wettable flanks are a desirable specification of certain automotive products.

Wettable flanks facilitate automatic inspection in order to check the correct welding of the package to the board.

Using wedge bonding technology together with a special lead design (recessed area), facilitates exposing a wire or ribbon portion (e.g., a "tail") outside the package sides. Those portions can be incorporated together with the leads by the solder, when a device is assembled on a board. In that way, the wires/ribbons are connected with respective leads and with the solder as well. In case a first connection (e.g., EC1) fails for any reason (wedge lift), a second connection (e.g., EC2) can compensate the first, thus maintaining device operation. Device reliability is improved.

Visual inspection on the package side (and/or 3D x-ray analysis), possibly facilitated by cross-section and/or decapsulation can reveal the lead recessed areas 200.

The extent of protection is determined by the annexed claims.

## Claims

1. A method, comprising:
arranging at least one semiconductor die (14) on a die pad (12A) at a first surface of a support substrate (12), the support substrate (12) having a first thickness (T1) between the first surface and a second surface opposite the first surface and comprising an array of electrically conductive leads (12B) around the die pad (12A), wherein electrically conductive leads (12B) in the array of electrically conductive leads (12B) have terminal recesses (200) at the first surface of the support substrate (12), wherein at said terminal recesses (200) said electrically conductive leads (12B) in the array of electrically conductive leads (12B) have a second thickness (T2) less than said first thickness (T1),
electrically coupling (16) the at least one semiconductor die (14) with said electrically conductive leads (12B) in the array of electrically conductive leads (12B) via electrically conductive elongated formations (16) having coupling ends (161, 162) to the electrically conductive leads (12B) in the array of electrically conductive leads (12B) arranged in said terminal recesses (200), and
partially cutting (SB') the support substrate (12) starting from the second surface, partially cutting (SB') being at said terminal recesses (200) and with a cutting thickness between the first thickness (T1) and the second thickness (T2), wherein the partial cutting (SB') produces exposed surfaces of the support substrate (1200A) and the coupling ends (1200B) of the electrically conductive elongated formations (16).

2. The method of claim 1, comprising molding an insulating encapsulation (18) onto the at least one semiconductor die (14) arranged on the die pad (12A) at the first surface of the support substrate (12), wherein the insulating encapsulation (18) leaves uncovered the exposed surfaces of the support substrate (1200A) and the coupling ends (1200B) of the electrically conductive elongated formations (16) produced by said partially cutting (SB').

3. The method of claim 1, wherein the electrically conductive elongated formations (16) having coupling ends (161, 162) arranged in said terminal recesses (200) comprise wires or ribbons.

4. The method of any of the previous claims, wherein said coupling ends (161, 162) of the electrically conductive elongated formations (16) to the electrically conductive leads (12B) in the array of electrically conductive leads (12B) arranged in said terminal recesses (200) comprise:
proximal portions (161) bonded to electrically conductive leads (12B) in the array of electrically conductive leads (12B) at said recesses (200), and
distal portions (162) projecting distally of the proximal portions (161) at said recesses (200) in the absence of bonding of the distal portion (162) to electrically conductive leads (12B) in the array of electrically conductive leads (12B).

5. The method of claim 4, comprising wedge bonding said proximal portions (161) to electrically conductive leads (12B) in the array of electrically conductive leads (12B) at said recesses (200).

6. The method of claim 4 or claim 5, wherein partially cutting (SB') at said terminal recesses (200) with a cutting thickness between the first thickness (T1) and the second thickness (T2) is at said distal portions (162) wherein the partial cutting (SB') produces exposed surfaces of the support substrate (1200A) and of the distal portions (162) of the coupling ends of the electrically conductive elongated formations (16).

7. The method of any of the previous claims, comprising mounting the support substrate (12) having the at least one semiconductor die (14) arranged on the die pad (12A) onto a mounting member (S) via solder material (SM) that wets and forms a solder meniscus at both exposed surfaces of the support substrate (1200A) and of the coupling ends (1200B) of the electrically conductive elongated formations (16).

8. A device (10), comprising:
at least one semiconductor die (14) arranged on a die pad (12A) at a first surface of a support substrate (12), the support substrate (12) having a first thickness (T1) between the first surface and a second surface opposite the first surface and comprising an array of electrically conductive leads (12B) around the die pad (12A),
terminal recesses (200) in electrically conductive leads (12B) in the array of electrically conductive leads (12B) at the first surface of the support substrate (12), wherein at said terminal recesses (200) said electrically conductive leads (12B) in the array of electrically conductive leads (12B) have a second thickness (T2) less than said first thickness (T1),
electrically conductive elongated formations (16) electrically coupling (16) the at least one semiconductor die (14) with said electrically conductive leads (12B) in the array of electrically conductive leads (12B), the electrically conductive elongated formations (16) having coupling ends (161, 162) to the electrically conductive leads (12B) in the array of electrically conductive leads (12B) arranged in said terminal recesses (200), **characterized by**
a partial cut (SB') in the support substrate (12) starting from the second surface, the partial cut (SB') being at said terminal recesses (200) and with a cutting depth between the first thickness (T1) and the second thickness (T2), wherein the partial cut (SB') leaves exposed surfaces of the support substrate (1200A) and the coupling ends (1200B) of the electrically conductive elongated formations (16).

9. The device (10) of claim 8, comprising an insulating encapsulation (18) molded onto the at least one semiconductor die (14) arranged on the die pad (12A) at the first surface of the support substrate (12), wherein the insulating encapsulation (18) leaves uncovered the exposed surfaces of the support substrate (1200A) and the coupling ends (1200B) of the electrically conductive elongated formations (16).

10. The device (10) of claim 8 or claim 9, wherein the electrically conductive elongated formations (16) having coupling ends (161, 162) arranged in said terminal recesses (200) comprise wires or ribbons.

11. The device (10) of any of claims 8 to 10, wherein said coupling ends (161, 162) to the electrically conductive leads (12B) in the array of electrically conductive leads (12B) arranged in said terminal recesses (200) comprise:
proximal portions (161) bonded, preferably wedge-bonded, to electrically conductive leads (12B) in the array of electrically conductive leads (12B) at said recesses (200), and
distal portions (162) projecting distally of the proximal portions (161) at said recesses (200) in the absence of bonding of the distal portion (162) to electrically conductive leads (12B) in the array of electrically conductive leads (12B).

12. An assembly comprising,
a semiconductor device mounting member (S), and
a device (10) according to any of claims 8 to 11 mounted onto said mounting member (S) via solder material (SM) exhibiting a solder meniscus at both exposed surfaces of the support substrate (1200A) and of the coupling ends (1200B) of the electrically conductive elongated formations (16).

13. A support substrate (12) for use in the method of any of claims 1 to 7, the support substrate (12) having said first thickness (T1) between the first surface and the second surface opposite the first surface and comprising said array of electrically conductive leads (12B) around the die pad (12A), the support substrate (12) having terminal recesses (200) in electrically conductive leads (12B) in the array of electrically conductive leads (12B) at the first surface of the support substrate (12), wherein at said terminal recesses (200) said electrically conductive leads (12B) in the array of electrically conductive leads (12B) have a second thickness (T2) less than said first thickness (T1), said terminal recesses (200) configured to have arranged therein the coupling ends (161, 162) of the electrically conductive elongated formations (16) that electrically couple (16) the at least one semiconductor die (14) with said electrically conductive leads (12B) in the array of electrically conductive leads (12B).

## Patentansprüche

1. Verfahren, das Folgendes umfasst:
Anordnen mindestens eines Halbleiterchips (14) auf einer Chipkontaktstelle (12A) an einer ersten Oberfläche eines Trägersubstrats (12), wobei das Trägersubstrat (12) eine erste Dicke (T1) zwischen der ersten Oberfläche und einer der ersten Oberfläche gegenüberliegenden zweiten Oberfläche aufweist und ein Array elektrisch leitender Stifte (12B) um die Chipkontaktstelle (12A) herum umfasst, wobei die elektrisch leitenden Stifte (12B) in dem Array elektrisch leitender Stifte (12B) Anschlussaussparungen (200) an der ersten Oberfläche des Trägersubstrats (12) aufweisen, wobei die elektrisch leitenden Stifte (12B) in dem Array elektrisch leitender Stifte (12B) an den Anschlussaussparungen (200) eine zweite Dicke (T2) aufweisen, die geringer ist als die erste Dicke (T1),
elektrisches Koppeln (16) des mindestens einen Halbleiterchips (14) mit den elektrisch leitenden Stiften (12B) in dem Array elektrisch leitender Stifte (12B) über elektrisch leitende längliche Formationen (16), die Kopplungsenden (161, 162) zu den elektrisch leitenden Stiften (12B) in dem Array elektrisch leitender Stifte (12B) aufweisen, die in den Anschlussaussparungen (200) angeordnet sind, und
teilweises Schneiden (SB') des Trägersubstrats (12) ausgehend von der zweiten Oberfläche, teilweises Schneiden (SB') an den Anschlussaussparungen (200) und mit einer Schnittdicke zwischen der ersten Dicke (T1) und der zweiten Dicke (T2), wobei das teilweise Schneiden (SB') freiliegende Oberflächen des Trägersubstrats (1200A) und der Kopplungsenden (1200B) der elektrisch leitenden länglichen Formationen (16) erzeugt.

2. Verfahren nach Anspruch 1, umfassend das Formen einer isolierenden Einkapselung (18) auf den mindestens einen Halbleiterchip (14), der auf der Chipkontaktstelle (12A) an der ersten Oberfläche des Trägersubstrats (12) angeordnet ist, wobei die isolierende Einkapselung (18) die freiliegenden Oberflächen des Trägersubstrats (1200A) und die Kopplungsenden (1200B) der elektrisch leitenden länglichen Formationen (16), die durch das teilweise Schneiden (SB') erzeugt wurden, unbedeckt lässt.

3. Verfahren nach Anspruch 1, wobei die elektrisch leitenden länglichen Formationen (16), die in den Anschlussaussparungen (200) angeordnete Kopplungsenden (161, 162) aufweisen, Drähte oder Bänder umfassen.

4. Verfahren nach einem der vorhergehenden Ansprüche, wobei die Kopplungsenden (161, 162) der elektrisch leitenden länglichen Formationen (16) zu den elektrisch leitenden Stiften (12B) in dem Array elektrisch leitender Stifte (12B), die in den Anschlussaussparungen (200) angeordnet sind, Folgendes umfassen:
proximale Abschnitte (161), die mit den elektrisch leitenden Stiften (12B) in dem Array elektrisch leitender Stifte (12B) an den Aussparungen (200) verbunden sind, und distale Abschnitte (162), die distal von den proximalen Abschnitten (161) an den Aussparungen (200) vorstehen, wenn keine Verbindung des distalen Abschnitts (162) mit den elektrisch leitenden Stiften (12B) in dem Array elektrisch leitender Stifte (12B) besteht.

5. Verfahren nach Anspruch 4, umfassend das Wedge-Bonden der proximalen Abschnitte (161) mit den elektrisch leitenden Stiften (12B) in dem Array elektrisch leitender Stifte (12B) an den Aussparungen (200).

6. Verfahren nach Anspruch 4 oder 5, wobei das teilweise Schneiden (SB') an den Anschlussaussparungen (200) mit einer Schnittdicke zwischen der ersten Dicke (T1) und der zweiten Dicke (T2) an den distalen Abschnitten (162) erfolgt, wobei das teilweise Schneiden (SB') freiliegende Oberflächen des Trägersubstrats (1200A) und der distalen Abschnitte (162) der Kopplungsenden der elektrisch leitenden länglichen Formationen (16) erzeugt.

7. Verfahren nach einem der vorhergehenden Ansprüche, umfassend das Montieren des Trägersubstrats (12), das den mindestens einen Halbleiterchip (14) aufweist, der auf der Chipkontaktstelle (12A) angeordnet ist, auf einem Montageelement (S) mittels eines Lötmaterials (SM), das an beiden freiliegenden Oberflächen des Trägersubstrats (1200A) und der Kopplungsenden (1200B) der elektrisch leitenden länglichen Formationen (16) einen Lötmeniskus benetzt und bildet.

8. Vorrichtung (10), die Folgendes umfasst:
mindestens einen Halbleiterchip (14), der auf einer Chipkontaktstelle (12A) an einer ersten Oberfläche eines Trägersubstrats (12) angeordnet ist, wobei das Trägersubstrat (12) eine erste Dicke (T1) zwischen der ersten Oberfläche und einer der ersten Oberfläche gegenüberliegenden zweiten Oberfläche aufweist und ein Array elektrisch leitender Stifte (12B) um die Kontaktstelle (12A) herum umfasst,
Anschlussaussparungen (200) in den elektrisch leitenden Stiften (12B) in dem Array elektrisch leitender Stifte (12B) an der ersten Oberfläche des Trägersubstrats (12), wobei an den Anschlussaussparungen (200) die elektrisch leitenden Stifte (12B) in dem Array elektrisch leitender Stifte (12B) eine zweite Dicke (T2) aufweisen, die geringer ist als die erste Dicke (T1),
elektrisch leitende längliche Formationen (16), die den mindestens einen Halbleiterchip (14) mit den elektrisch leitenden Stiften (12B) in dem Array elektrisch leitender Stifte (12B) elektrisch koppeln (16), wobei die elektrisch leitenden länglichen Formationen (16) Kopplungsenden (161, 162) zu den elektrisch leitenden Stiften (12B) in dem Array elektrisch leitender Stifte (12B) aufweisen, die in den Anschlussaussparungen (200) angeordnet sind,
**gekennzeichnet durch**
einen Teilschnitt (SB') in dem Trägersubstrat (12) ausgehend von der zweiten Oberfläche, wobei sich der Teilschnitt (SB') an den Anschlussaussparungen (200) befindet und mit einer Schnitttiefe zwischen der ersten Dicke (Tl) und der zweiten Dicke (T2), wobei der Teilschnitt (SB') freiliegende Oberflächen des Trägersubstrats (1200A) und der Kopplungsenden (1200B) der elektrisch leitenden länglichen Formationen (16) hinterlässt.

9. Vorrichtung (10) nach Anspruch 8, die eine isolierende Einkapselung (18) umfasst, die auf den mindestens einen Halbleiterchip (14) geformt ist, der auf der Chipkontaktstelle (12A) an der ersten Oberfläche des Trägersubstrats (12) angeordnet ist, wobei die isolierende Einkapselung (18) die freiliegenden Oberflächen des Trägersubstrats (1200A) und die Kopplungsenden (1200B) der elektrisch leitenden länglichen Formationen (16) unbedeckt lässt.

10. Vorrichtung (10) nach Anspruch 8 oder 9, wobei die elektrisch leitenden länglichen Formationen (16), die in den Anschlussaussparungen (200) angeordnete Kopplungsenden (161, 162) aufweisen, Drähte oder Bänder umfassen.

11. Vorrichtung (10) nach einem der Ansprüche 8 bis 10, wobei die Kopplungsenden (161, 162) zu den elektrisch leitenden Stiften (12B) in dem Array elektrisch leitender Stifte (12B), die in den Anschlussaussparungen (200) angeordnet sind, Folgendes umfassen:
proximale Abschnitte (161), die mit den elektrisch leitenden Stiften (12B) in dem Array elektrisch leitender Stifte (12B) an den Aussparungen (200) verbunden sind, vorzugsweise durch Wedge-Bonden, und
distale Abschnitte (162), die distal von den proximalen Abschnitten (161) an den Aussparungen (200) vorstehen, wenn keine Verbindung des distalen Abschnitts (162) mit den elektrisch leitenden Stiften (12B) in dem Array elektrisch leitender Stifte (12B) besteht.

12. Baugruppe, umfassend
ein Halbleitervorrichtungs-Montageelement (S), und
eine Vorrichtung (10) nach einem der Ansprüche 8 bis 11, die mittels eines Lötmaterials (SM) auf dem Montageelement (S) montiert ist, das an beiden freiliegenden Oberflächen des Trägersubstrats (1200A) und der Kopplungsenden (1200B) der elektrisch leitenden länglichen Formationen (16) einen Lötmeniskus aufweist.

13. Trägersubstrat (12) zur Verwendung im Verfahren nach einem der Ansprüche 1 bis 7, wobei das Trägersubstrat (12) die erste Dicke (T1) zwischen der ersten Oberfläche und der der ersten Oberfläche gegenüberliegenden zweiten Oberfläche aufweist und das Array elektrisch leitender Stifte (12B) um die Chipkontaktstelle (12A) herum umfasst, wobei das Trägersubstrat (12) Anschlussaussparungen (200) in den elektrisch leitenden Stiften (12B) in dem Array elektrisch leitender Stifte (12B) an der ersten Oberfläche des Trägersubstrats (12) aufweist, wobei an den Anschlussaussparungen (200) die elektrisch leitenden Stifte (12B) in dem Array elektrisch leitenden Stifte (12B) eine zweite Dicke (T2) aufweisen, die geringer ist als die erste Dicke (T1), wobei die Anschlussaussparungen (200) so eingerichtet sind, dass sie darin die Kopplungsenden (161, 162) der elektrisch leitenden länglichen Formationen (16) angeordnet haben, die den mindestens einen Halbleiterchip (14) mit den elektrisch leitenden Stiften (12B) in dem Array elektrisch leitender Stifte (12B) elektrisch koppeln (16).

## Revendications

1. Procédé, comprenant :
d'agencer au moins une puce de semi-conducteur (14) sur une pastille de connexion (12A) au niveau d'une première surface d'un substrat de support (12), le substrat de support (12) ayant une première épaisseur (T1) entre la première surface et une seconde surface à l'opposé de la première surface et comprenant un réseau de broches électriquement conductrices (12B) autour de la pastille de connexion (12A), dans lequel des broches électriquement conductrices (12B) dans le réseau de broches électriquement conductrices (12B) comportent des évidements de borne (200) au niveau de la première surface du substrat de support (12), dans lequel au niveau desdits évidements de borne (200) lesdites broches électriquement conductrices (12B) dans le réseau de broches électriquement conductrices (12B) ont une seconde épaisseur (T2) inférieure à ladite première épaisseur (T1),
de coupler électriquement (16) l'au moins une puce de semi-conducteur (14) avec lesdites broches électriquement conductrices (12B) dans le réseau de broches électriquement conductrices (12B) via des formations allongées électriquement conductrices (16) ayant des extrémités de couplage (161, 162) aux broches électriquement conductrices (12B) dans le réseau de broches électriquement conductrices (12B) agencées dans lesdits évidements de borne (200), et
de découper partiellement (SB') le substrat de support (12) en partant de la seconde surface, la découpe partielle (SB') étant au niveau desdits évidements de borne (200) et avec une épaisseur de découpe entre la première épaisseur (T1) et la seconde épaisseur (T2), dans lequel la découpe partielle (SB') produit des surfaces exposées du substrat de support (1200A) et des extrémités de couplage (1200B) des formations allongées électriquement conductrices (16).

2. Procédé selon la revendication 1, comprenant de mouler un enrobage isolant (18) sur l'au moins une puce de semi-conducteur (14) agencée sur la pastille de connexion (12A) au niveau de la première surface du substrat de support (12), dans lequel l'enrobage isolant (18) laisse découvertes les surfaces exposées du substrat de support (1200A) et des extrémités de couplage (1200B) des formations allongées électriquement conductrices (16) produites par ladite découpe partielle (SB').

3. Procédé selon la revendication 1, dans lequel les formations allongées électriquement conductrices (16) comportant des extrémités de couplage (161, 162) agencées dans lesdits évidements de borne (200) comprennent des fils ou des rubans.

4. Procédé selon l'une quelconque des revendications précédentes, dans lequel lesdites extrémités de couplage (161, 162) des formations allongées électriquement conductrices (16) aux broches électriquement conductrices (12B) dans le réseau de broches électriquement conductrices (12B) agencées dans lesdits évidements de borne (200) comprennent :
des parties proximales (161) liées aux broches électriquement conductrices (12B) dans le réseau de broches électriquement conductrices (12B) au niveau desdits évidements de borne (200), et
des parties distales (162) faisant saillie distalement depuis les parties proximales (161) au niveau desdits évidements de borne (200) en l'absence liaison des parties distales (162) aux broches électriquement conductrices (12B) dans le réseau de broches électriquement conductrices (12B).

5. Procédé selon la revendication 4, comprenant de souder en coin lesdites parties proximales (161) sur les broches électriquement conductrices (12B) dans le réseau de broches électriquement conductrices (12B) au niveau desdits évidements de borne (200).

6. Procédé selon la revendication 4 ou la revendication 5, dans lequel la découpe partielle (SB') au niveau desdits évidements de borne (200) avec une épaisseur de découpe entre la première épaisseur (T1) et la seconde épaisseur (T2) est au niveau desdits parties distales (162) dans lequel la découpe partielle (SB') produit des surfaces exposées du substrat de support (1200A) et des parties distales (162) des extrémités de couplage des formations allongées électriquement conductrices (16).

7. Procédé selon l'une quelconque des revendications précédentes, comprenant de monter le substrat de support (12) ayant l'au moins une puce de semi-conducteur (14) agencée sur la pastille de connexion (12A) sur un élément de montage (S) via un matériau de soudure (SM) qui mouille et forme un ménisque de soudure au niveau des deux surfaces exposées du substrat de support (1200A) et des extrémités de couplage (1200B) des formations allongées électriquement conductrices (16).

8. Dispositif (10), comprenant :
au moins une puce de semi-conducteur (14) agencée sur une pastille de connexion (12A) au niveau d'une première surface d'un substrat de support (12), le substrat de support (12) ayant une première épaisseur (T1) entre la première surface et une seconde surface à l'opposé de la première surface et comprenant un réseau de broches électriquement conductrices (12B) autour de la pastille de connexion (12A),
des évidements de borne (200) dans des broches électriquement conductrices (12B) dans le réseau de broches électriquement conductrices (12B) au niveau de la première surface du substrat de support (12), dans lequel au niveau desdits évidements de borne (200) lesdites broches électriquement conductrices (12B) dans le réseau de broches électriquement conductrices (12B) ont une seconde épaisseur (T2) inférieure à ladite première épaisseur (T1),
des formations allongées électriquement conductrices (16) couplant électriquement (16) l'au moins une puce de semi-conducteur (14) auxdites broches électriquement conductrices (12B) dans le réseau de broches électriquement conductrices (12B), les formations allongées électriquement conductrices (16) comportant des extrémités de couplage (161, 162) aux broches électriquement conductrices (12B) dans le réseau de broches électriquement conductrices (12B) agencées dans lesdits évidements de borne (200), **caractérisé par**
une découpe partielle (SB') dans le substrat de support (12) en partant de la seconde surface, la découpe partielle (SB') étant au niveau desdits évidements de borne (200) et avec une profondeur de découpe entre la première épaisseur (T1) et la seconde épaisseur (T2), dans lequel la découpe partielle (SB') laisse des surfaces exposées du substrat de support (1200A) et des extrémités de couplage (1200B) des formations allongées électriquement conductrices (16).

9. Dispositif (10) selon la revendication 8, comprenant un enrobage isolant (18) moulé sur l'au moins une puce de semi-conducteur (14) agencée sur la pastille de connexion (12A) au niveau de la première surface du substrat de support (12), dans lequel l'enrobage isolant (18) laisse découvertes les surfaces exposées du substrat de support (1200A) et des extrémités de couplage (1200B) des formations allongées électriquement conductrices (16).

10. Dispositif (10) selon la revendication 8 ou la revendication 9, dans lequel les formations allongées électriquement conductrices (16) ayant des extrémités de couplage (161, 162) agencées dans lesdits évidements de borne (200) comprennent des fils ou des rubans.

11. Dispositif (10) selon l'une quelconque des revendications 8 à 10, dans lequel lesdites extrémités de couplage (161, 162) aux broches électriquement conductrices (12B) dans le réseau de broches électriquement conductrices (12B) agencées dans lesdits évidements de borne (200) comprennent :
des parties proximales (161) liées aux broches électriquement conductrices (12B) dans le réseau de broches électriquement conductrices (12B) au niveau desdits évidements de borne (200), et
des parties distales (162) faisant saillie distalement depuis les parties proximales (161) au niveau desdits évidements de borne (200) en l'absence de liaison des parties distales (162) sur des broches électriquement conductrices (12B) dans le réseau de broches électriquement conductrices (12B).

12. Assemblage comprenant,
un élément de montage de dispositif semi-conducteur (S), et
un dispositif (10) selon l'une quelconque des revendications 8 à 11 monté sur ledit élément de montage (S) via un matériau de soudure (SM) présentant un ménisque de soudure au niveau des deux surfaces exposées du substrat de support (1200A) et des extrémités de couplage (1200B) des formations allongées électriquement conductrices (16).

13. Substrat de support (12) pour utiliser dans le procédé selon l'une quelconque des revendications 1 à 7, le substrat de support (12) ayant ladite première épaisseur (T1) entre la première surface et la seconde surface à l'opposé de la première surface et comprenant ledit réseau de broches électriquement conductrices (12B) autour de la pastille de connexion (12A), le substrat de support (12) comportant des évidements de borne (200) dans des broches électriquement conductrices (12B) dans le réseau de broches électriquement conductrices (12B) au niveau de la première surface du substrat de support (12), dans lequel au niveau desdits évidements de borne (200) lesdites broches électriquement conductrices (12B) dans le réseau de broches électriquement conductrices (12B) ont une seconde épaisseur (T2) inférieure à ladite première épaisseur (T1), lesdits évidements de borne (200) configurés pour avoir agencés dedans les extrémités de couplage (161, 162) des formations allongées électriquement conductrices (16) qui couplent électriquement (16) l'au moins une puce de semi-conducteur (14) auxdites broches électriquement conductrices (12B) dans le réseau de broches électriquement conductrices (12B).
